# EUROPÄISCHE PATENTSCHRIFT

(11) **EP 0 925 713 B1**
(45) Veröffentlichungstag und Bekanntmachung des Hinweises auf die Patenterteilung: **19.07.2000**
(21) Anmeldenummer: 97937435.2
(22) Anmeldetag: 08.08.1997
(51) Int. Cl.: H05K 1/00, H01R 13/66, H02G 15/007, H02B 1/20

(54) **FLEXIBLE LEITERBAHNVERBINDUNG**
FLEXIBLE CONDUCTIVE TAPE CONNECTION
LIAISON SOUPLE A PISTES CONDUCTRICES

(30) Priorität: 16.09.1996 DE 19637626
(43) Veröffentlichungstag der Anmeldung: 30.06.1999
(73) Patentinhaber: ROBERT BOSCH GMBH, 70442 Stuttgart (DE)
(72) Erfinder: MOESSINGER, Juergen, D-74189 Weinsberg (DE); GROTE, Walter, D-71706 Markgröningen (DE)
(86) Internationale Anmeldenummer: DE9701675
(87) Internationale Veröffentlichungsnummer: WO9812902

(56) Entgegenhaltungen:
- DE-A- 4 325 980
- US-A- 4 703 649
- US-A- 4 800 461
- US-A- 5 198 391
- US-A- 5 481 795

## Beschreibung

Die Erfindung betrifft eine flexible Leiterbahnverbindung, insbesondere für ein Steuer- oder Regelgerät mit einem abgesetzten Sensor- oder Stellglied, nach dem Oberbegriff des Hauptanspruchs.

Bei einer aus der DE 40 38 394 A1 bekannten flexiblen Leiterbahnverbindung wird eine elektrische Verbindung zwischen einer Steuereinrichtung für eine Magnetventil in einem Kraftfahrzeug und einem Winkelsensor zur Erfassung des Drehwinkels der Antriebswelle einer Kraftstoffeinspritzpumpe hergestellt. Der Winkelsensor wird über die in einer flexiblen Folie befindlichen Leiterbahnen mit einer elektrischen Spannung versorgt und gibt ein Sensorsignal an die Steuereinrichtung ab.

Die flexible Folie ist beim bekannten Winkelsensor zwischen dem Deckel und dem Gehäuse eingespannt, so daß im Betrieb des Aggregats, an dem der Winkelsensor befestigt ist, mechanische Schwingungen des Aggregats auf die flexible Folie übertragen werden. Beispielsweise bei einer Anwendung des Winkelsensors an der Pumpenwelle einer Kraftstoffeinspritzpumpe eines Kraftfahrzeuges können dabei, insbesondere von der Zylinderzahl abhängige Stöße auf die flexible Folie übertragen werden. Die Anzahl der Stöße ist dabei von der Zylinderzahl des Verbrennungsmotors abhängig. Diese relativ häufigen und kurzen Stöße können zu einem Bruch der Leiterbahnen in der Folie, bevorzugt an der Einspannstelle der flexiblen Folie zwischen dem Deckel und dem Gehäuse des Winkelsensors, und damit zu Fehlfunktionen führen.

### Vorteile der Erfindung

Die Oberbegriffe der Ansprüche 1und 3 sind jeweils DE-A-4 325 980 zu entnehmen. Die flexible Leiterbahnverbindung ist in der erfindungsgemäßen Weiterbildung mit den kennzeichnenden Merkmalen des Anspruchs 1, bzw. 3 dadurch vorteilhaft daß durch die Schleife in der flexiblen Folienebst der zusätzlichen Dehnbrücke bzw. in den Leiterbahnen ein Puffer für die mechanischen Stöße geschaffen wird. Durch die Stöße auf die flexible Folie wird hierbei in der Folie und den Leiterbahnen eine Längenänderung in der Größenordnung von 0 bis 300 µm verursacht. Der Einbau der erfindungsgemäßen Schleifen führt zu einer Verringerung der durch die Stöße hervorgerufenen Dehnungen und der mechanischen Spannung in den Leiterbahnen und der flexiblen Folie.

Diese auch mit den Weiterbildungen der Unteransprüche erfolgreich vorgenommene Verringerung der Dehnungen in den Leiterbahnen bei den einzelnen Stößen erhöht die Langzeithaltbarkeit der Leiterbahnen, wodurch der Ausfall des Sensors als externes Bauelement durch Leiterbahnbruch in der flexiblen Folie während der Betriebsdauer der Anordnung weitgehend verhindert ist.

### Zeichnung

Ausführungsbeispiele eines erfindungsgemäßen Ausführungsbeispiels einer flexiblen Leiterbahnverbindung werden anhand der Zeichnung erläutert. Es zeigen:
Figur 1 eine Draufsicht auf einen Drehwinkelsensor als externes Bauelement mit einer flexiblen Leiterbahnverbindung zu Teilen einer Steuergeräteanordnung;
Figur 2 einen Schnitt durch den Drehwinkelsensor;
Figur 3 eine Ansicht eines ersten Ausführungsbeispiels einer Schleife in der flexiblen Folie;
Figur 4 ein Ausführungsbeispiel nach Figur 3 mit einer Ausfüllung in der Schleife und
Figur 5 eine Ansicht eines zweiten Ausführungsbeispiels.

### Beschreibung der Ausführungsbeispiele

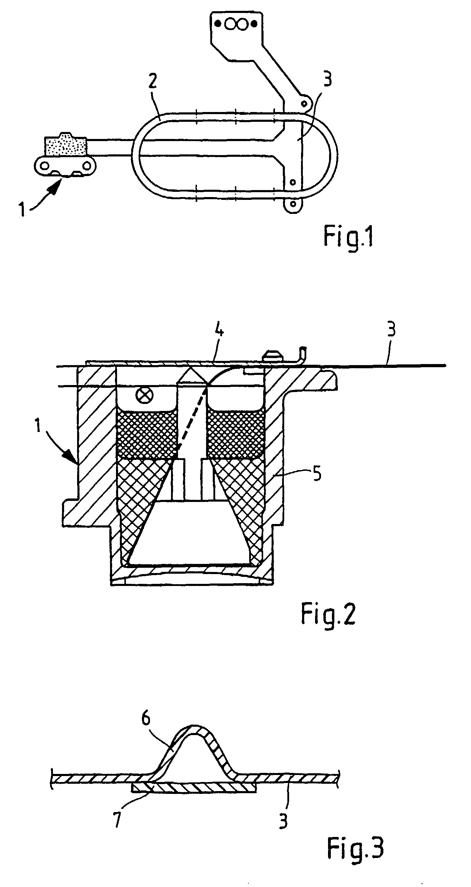

In Figur 1 der Zeichnung ist ein Gehäuse eines Drehwinkelsensors 1, Teile einer Steuereinrichtung 2 und eine flexible Leiterbahnverbindung 3 gezeigt. Der Drehwinkelsensor 1 dient zur Erfassung des Drehwinkels einer Antriebswelle zur Steuerung einer Kraftstoffeinspritzpumpe eines hier nicht dargestellten Kraftfahrzeugs.

Aus der Schnittdarstellung nach Figur 2 ist erkennbar, daß die flexible Leiterbahnfolie 3 zwischen einem Deckel 4 und einem Gehäuse 5 eingespannt ist. Der eigentliche, hier nicht näher erläuterte Drehwinkelsensor im Gehäuse 5 befindet sich im Bereich der Kraftstoffpumpeneinrichtung und somit ist das Gehäuse den mechanischen Schwingungen der Kraftstoffpumpe ausgesetzt.

Ein erfindungsgemäßes Ausführungsbeispiel nach Figur 3 weist einen Puffer als Schleife 6 im Verlauf der flexiblen Leiterbahnfolie 3 auf, um die Dehnung der Leiterbahnen in der flexiblen Folie 3 bei den Stoßbewegungen der Kraftstoffpumpe zu verringern. Die Schleife 6 kann in die flexible Folie 3 eingeprägt sein oder mittels einer Überbrückung 7 aus dehnbaren Material, welches an den Endpunkten der Schleife 6 fixiert ist, gebildet werden.

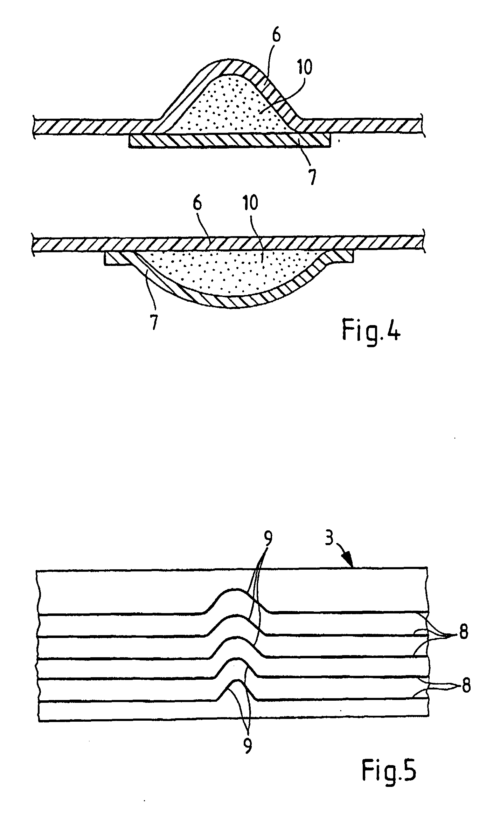

Bei der Weiterbildung nach Figur 4 ist im oberen Teil ein elastisches Füllmaterial 10 zu erkennen, das bei einer geringen Zugbelastung dazu führt, daß die Schleife 6 unterhalb einer vergegebenen Schwelle bei normalen Betriebsbedingungen keine Veränderung der Schleifengeometrie aufgrund der Steifigkeit des Füllmaterials erfolgt. Erst wenn eine größere Zugbelastung auftritt wird die Schleife 6 gerade gezogen und eine Verformung der Überbrückung 7 mitsamt des Füllmaterials 10 bewirkt.

Gemäß einem zweiten Ausführungsbeispiel nach Figur 5 sind die Leiterbahnen 8 mit einer schleifenförmigen Auslenkung 9 versehen und damit in die flexible Folie 3 eingeprägt. Die Breite der Leiterbahnen 8 beträgt hierbei vorzugsweise ca. 300 bis 700 µm (insbesondere 400 µm), damit die Flexibilität gewährleistet ist.

Der Einbau der vorhergehend beschriebenen Schleifen 6 oder 9 ist nicht an das Material (vorzugsweise Polyamid) gebunden; der Ort der Schleifen sollte sich in der Nähe der Einspannstelle zwischen dem Gehäuse 5 und dem Deckel 4 des Drehwinkelsensors 1 (siehe Figur 1) befinden um die mechanischen Stöße wirkungsvoll abzufangen. In bestimmten Anwendungsfällen können auch mehrere Schleifen 6 oder 9 hintereinander angeordnet werden.

## Patentansprüche

1. Flexible Leiterbahnverbindung, mit der
- elektrische Verbindungen zwischen einem elektrischen Gerät (2) und einem externen Bauteil (1) herstellbar sind, wobei sich die Leiterbahnen (8) in oder auf einer flexiblen Folie (3) befinden, die sowohl am elektrischen Gerät (2) als auch am externen Bauteil (1) eingespannt ist,
- die flexible Folie (3) in einem vorgegebenen Bereich im Verlauf der Leiterbahnen (8) eine Schleife (5) senkrecht zur Folienebene aufweist,
**dadurch gekennzeichnet, daß**
- die Schleife (6) mit einem dehnbaren Material (7) überbrückt ist, wobei das dehnbare Material (7) an den Endpunkten der Schleife (6) fixiert ist.

2. Flexible Leiterbahnverbindung nach Anspruch 1, **dadurch gekennzeichnet, daß**
- der Bereich zwischen der Schleife (6) und der Überbrükkung mit dem dehnbaren Material (7) mit einem elastischen Material (10) ausgefüllt ist.

3. Flexible Leiterbahnverbindung, mit der
- elektrische Verbindungen zwischen einem elektrischen Gerät (2) und einem externen Bauteil (1) herstellbar sind, wobei sich die Leiterbahnen (8) in oder auf einer flexiblen Folie (3) befinden, die sowohl am elektrischen Gerät (2) als auch am externen Bauteil (1) eingespannt ist, **dadurch gekennzeichnet, daß**
- die Leiterbahnen (8) mit jeweils einer schleifenförmigen Auslenkung (9) versehen und damit in die Flexible Folie eingeprägt sind, wobei die Auslenkungen in der Folienebene senkrecht zum Leiterbahnverlauf angeordnet sind.

4. Flexible Leiterbahnverbindung nach Anspruch 3, **dadurch gekennzeichnet, daß**
- die Leiterbahnen (8) eine Breite von ca. 300 bis 700 µm aufweisen.

5. Flexible Leiterbahnverbindung nach einem der vorhergehenden Ansprüche, **dadurch gekennzeichnet, daß**
- das externe Bauteil (3) ein Sensor ist, der mechanischen Schwingungen ausgesetzt ist und das elektrische Gerät (2) Bestandteil einer Steuergeräteanordnung ist, die das Sensorsignal auswertet.

6. Flexible Leiterbahnverbindung nach einem der vorhergehenden Ansprüche, **dadurch gekennzeichnet, daß**
- die flexible Folie (3) aus Polyamid und die Leiterbahnen (8) aus einer Kupferlegierung bestehen.

## Claims

1. Flexible conductor track connection, with which
- electrical connections can be established between an electrical device (2) and an external component (1), the conductor tracks (8) being located in or on a flexible film (3), which is clamped both to the electrical device (2) and to the external component (1),
- the flexible film (3) has in a predetermined region in the path of the conductor tracks (8) a loop (6) perpendicular to the plane of the film,
characterized in that
- the loop (6) is bridged by an extensible material (7), the extensible material (7) being fixed at the end points of the loop (6).

2. Flexible conductor track connection according to Claim 1, characterized in that
- the region between the loop (6) and the bridging by the extensible material (7) is filled with elastic material (10).

3. Flexible conductor track connection, with which
- electrical connections can be established between an electrical device (2) and an external component (1), the conductor tracks (8) being located in or on a flexible film (3), which is clamped both to the electrical device (2) and to the external component (1), characterized in that
- the conductor tracks (8) are provided with in each case a loop-shaped deflection (9) and are impressed in this way in the flexible film, the deflections being arranged in the plane of the film perpendicular to the path of the conductor tracks.

4. Flexible conductor track connection according to Claim 3, characterized in that
- the conductor tracks (8) have a width of approximately 300 to 700 µm.

5. Flexible conductor track connection according to one of the preceding claims, characterized in that
- the external component (3) is a sensor which is exposed to mechanical vibrations and the electrical device (2) is a component part of a control device arrangement which evaluates the sensor signal.

6. Flexible conductor track connection according to one of the preceding claims, characterized in that
- the flexible film (3) consists of polyamide and the conductor tracks (8) consist of a copper alloy.

## Revendications

1. Liaison souple à pistes conductrices qui réalise des connexions électriques entre un appareil électrique (2) et un composant externe (1), dans laquelle :
- les pistes conductrices (8) se trouvent dans ou sur une feuille souple (3) insérée aussi bien sur l'appareil électrique (2) que sur le composant externe (1),
- la feuille souple (3) présente dans une zone prédéterminée sur le parcours des pistes conductrices (8) un lacet (6) perpendiculaire au plan de la feuille,
caractérisée en ce que
- le lacet (6) est ponté par une matière extensible (7), la matière extensible (7) étant fixée aux points terminaux du lacet (6).

2. Liaison souple à pistes conductrices, selon la revendication 1,
caractérisée en ce que
la zone comprise entre le lacet (6) et le pontage est remplie avec la matière extensible (7) par une matière élastique (10).

3. Liaison souple à pistes conductrices, avec laquelle :
- on peut réaliser des liaisons électriques entre un appareil électrique (2) et un composant externe (1), les pistes conductrices (8) se trouvant dans ou sur une feuille souple (3), qui est insérée aussi bien sur l'appareil électrique (2) que sur le composant externe (1),
caractérisée en ce que
- les pistes conductrices (8) sont respectivement pourvues d'une extension en forme de lacet (9) et sont de cette façon insérées dans la feuille souple, les extensions étant disposées dans le plan de la feuille perpendiculairement au parcours des pistes conductrices.

4. Liaison souple à pistes conductrices, selon la revendication 3,
caractérisée en ce que
les pistes conductrices (8) présentent une largeur d'environ 300 à 700 µm.

5. Liaison souple à pistes conductrices, selon l'une des revendications précédentes,
caractérisée en ce que
le composant externe (3) est un détecteur, qui est exposé à des oscillations mécaniques et l'appareil électrique (2) est un composant d'un agencement d'appareil de commande, qui exploite le signal du détecteur.

6. Liaison souple à pistes conductrices, selon l'une des revendications précédentes,
caractérisée en ce que
la feuille souple (3) est réalisée en polyamide et les pistes conductrices (8) en un alliage à base de cuivre.
